Europäisches Patentamt

**European Patent Office**

**Office européen des brevets**

(11) Publication number: **0 166 065**
A1

# EUROPEAN PATENT APPLICATION

(21) Application number: **84830198.2**

(22) Date of filing: **29.06.84**

(51) Int. Cl.⁴: **G 01 R 29/24**, G 10 K 11/36, H 03 H 9/42

(43) Date of publication of application: **02.01.86** Bulletin 86/1

(84) Designated Contracting States: **AT BE CH DE FR GB LI LU NL SE**

(71) Applicant: **CONSIGLIO NAZIONALE DELLE RICERCHE, Piazzale Aldo Moro, 7, I-00185 Roma (IT)**

(72) Inventor: **Palma, Antonio, Via Barnaba Tortolini 13, I-00197 Roma (IT)**
Inventor: **Socino, Giovanni, Via Montemignaio 15, I-00189 Roma (IT)**
Inventor: **Verona, Enrico, Via Vetulonia 90, I-00183 Roma (IT)**
Inventor: **Gatti, Emilio, Via Lambro 32, I-20050 Lesmo (Milano) (IT)**

(74) Representative: **Moriconi, Franco et al, Via Piemonte 26, I-00187 Roma (IT)**

(54) **Voltage sensor utilizing a surface wave electroacoustic structure sensible to the electric field.**

(57) A voltage sensor consisting of a surface wave electroacoustic device, comprising a plate of film of piezoelectric material (20), on the opposite faces of which two contactor field metal films (23, 24) are placed for applying an unknown p.d. (25, 26) potential difference). On one face of the plate there are applied also two electroacoustic transductor means (21, 22) The application of the p.d. to the two field films causes the physical characteristics of the plate to modify owing to the piezoelectric effect, whereby it changes also the propagation rate of the acoustic wave. This variation of the propagation rate is detected and measured. Some embodiments of both the sensor and measurement circuitries are disclosed for several applications.

-1-

## VOLTAGE SENSOR UTILIZING A SURFACE WAVE ELECTROACOUSTIC STRUCTURE SENSIBLE TO THE ELECTRIC FIELD

The present invention relates to a voltage sensor device including detector means, the physical characteristics of which are sensitive to possible electric fields. More particularly, the present invention refers to a voltage sensor device comprising a plate of piezoelectric material submitted to the action of the p.d. to be measured and having on one of its faces a surface wave electroacoustic means, by which a modification of the physical characteristics of the piezoelectric plate, due to the application of an unknown potential difference, causes a variation of the propagation rate of the acoustic surface waves. Such variation of the propagation rate is then detected and measured for obtaining the value of the unknown p.d.

Before disclosing the structure of the device according to the invention, it would be advisable to make a short account inherent to the surface acoustic waves.

By the term "surface acoustic waves" (SAW) there are generally included all the mechanical waves which propagate on the free surface of a solid body. A common characteristic of the surface waves is that almost all the acoustic energy is concentrated within a surface layer having a thickness corresponding to about the length of the acoustic wave in useful propagation.

Moreover, the profile of the acoustic field does not change during the propagation owing to the diffraction phenomena, but remain un-

-2-

varied because its behaviour is determined only by the elastic conditions at boundary. .. The family of these waves is extremely wide, as it results from several parameters which determine them: curvature of the substrate surface, elastic characteristics of the propagation medium, homogeneity degree of the medium, interactive with the electric field and electric charges, conformation of the acoustic field (flate wave, cylindric or spheric wave or more complex waves).

A wave type, to be considered as fundamental and more interesting from the point of view of its applications, is the Rayleigh wave, the sole elastic wave type which may propagate on the free and flate surface of an isotrope solid or of a crystal (generalized Rayleigh waves) with a propagation rate somewhat lower than that of the transverse volume waves in the same material.

The motion of the particles of the material, in which the propagation takes place, is submitted to a dependance of elliptic kind. In the isotrope materials the greater axis of the ellipse is orthogonal to the propagation plane, whereas the smaller axis is parallel to the propagation direction.

In the crystals, excepted some directions of a higher symmetry degree, the motion of the particles is always of elliptic kind and there are three displacement components. Towards the inside of the material the components of the vibration amplitude quickly decrease and the energy of the wave becomes negligeable at a depth higher than the wave length. Therefore, the Rayleigh wave may be considered as a wave of bidimensional type.

For several years, scismotogists only have investigated the surface waves. Recently, the introduction of the interdigital transductors consisting of a periodic structure of metal electrodes carried out directly on the propagation surface of piezoelectric material by

-3-

using photolithographic techniques developed for performing electronic microcircuits - has allowed the solution of problems connected with both the generation and detection of the high frequency surface waves. The solution of said problems has consequently allowed to carry out electroacoustic devices adapted to execute complex processings of electric signals throughout the frequency ranges up to $GH_z$.

Any alteration of the propagation surface of the surface waves modifies the acoustic properties of the substrate causing thus the variation of both the propagation rate and attenuation.

Specifically, if a thin film is used, it can change the electric constants of the substrate, the real mass of the oscillating particles and, for the piezoelectric means, the electric conditions at the boundary.

In the field of the electronics there are generally used the following piezoelectric materials for the substrates of surface acoustic wave devices:

A. $LiNbO_3$ (lithium niobate) with the following crystallographic orientations:

1) cut y - proagation 2

2) cut y - propagation x

3) rotation of 41.5° with respect to y - propagation x

B. $LiTaO_3$ (lithium tantalate) with the following crystallographic orientations:

1) cut y - propagation 2

2) cut x - propagation y

3) cut 2 - propagation y

C. $B_{12}G_eO_{20}$ (bismuth germanate)
cut (001) - propagation 110

D. $S_iO_2$ (quartz)

cut y - propagation x

cut x - propagation y

cut ST - propagation x

(temperature coefficient null at ambient temperature).

The main differences among the above identified materials consist in:

a)    different propagation rate of the surface acoustic wave

b)    different temperature coefficient

c)    different coefficient of electromechanic coupling.

Since some time the technology of the surface acoustic wave devices prefers to use non-piezoelectric substrates, on which there is placed an epitaxial piezoelectric film (usually ZnO zinc oxide or AlN aluminium nitride).

Further details about the surface acoustic waves and their applications, may be found in the following references:

1) Rayleigh Lord - On waves propagated along the place surface of an elastic solid - Proceedings of the London Mathematical Society, vol. 17 (1885) p. 4

2) Schoch A. - Schallreflexion, Schallbrechung und Schallbeugung - Ergebnisse der Exakten Naturwissenschaften, vol. 23 (1950) -p. 127

3) Ewing W.M. Jardetsky W.S. and Press F. - Elastic waves in layered media - McGraw Hill, New York (1957)

4) Brekhovskikh LM - Waves in layered media - Academic Press, New York, London (1960)

5) Viktorov I.A. - Rayleigh and Lamb waves - Plenum, New York (1967)

6) White R.M. Surace elastic waves - Proceedings of the IEEE, volume 58 (1970) - p. 1238

7) Farnell G.W. and Adler F.L. - Elastic wave propagation in thin layers - Physical Acoustics, ed. Mason W.P. and Thurston R.N., vol. 9 (1972), p. 35

0166065

-5-

8) Auld B.A. - Acoustic fields and waves in solids - John Wiley and Sons, vol. 2 (1973)

9) Ueberall H. - Surface waves in acoustics - Physicals Acoustics, Ed. Mason W.P. and Thurston R.N., vol. 10 (1973), p. 1.

As herebefore mentioned, the physical principle of the surface acoustic waves may be utilized for carrying out a voltage sensor by means of a structure sensitive, in physical terms, to the application of an unknown p.d. which influences the substrate portion, in which the surface acoustic waves propagate, causing the modification of the elastic characteristics.

Further details and advantages will result from the following disclosure of some preferred embodiments of the present invention, shown in the enclosed drawings, in which:

Fig. 1 shows a portion of the structure of a typical surface acoustic wave device;

Fig. 2 shows a schematical view of an embodiment of the voltage sensor, in which an electroacoustic surface acoustic wave structure according to the present invention is used;

Fig. 3 shows a first embodiment of the circuit detecting the variations of the physic constants of the voltage sensor in dependance on the voltage to be detected;

Figs. 4a, b,c and d show different embodiments and connections of the sensor;

Figs. 5a,b,and c show different embodiments and connections of the voltage sensor, with selfoscillating conformations;

Fig. 6 shows an embodiment in which a non-piezoelectric substrate is used, with a superposed thin piezoelectric film.

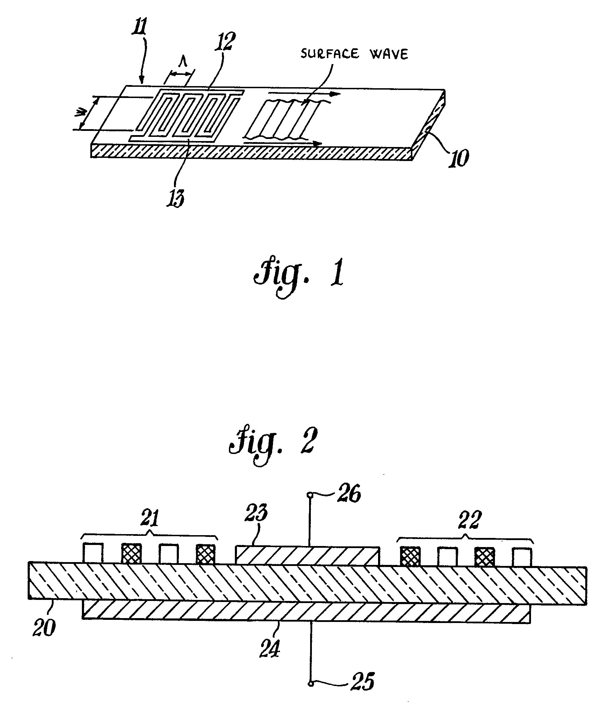

Referring now to Fig. 1, a typical surface acoustic wave base device comprises a substrate 10 of piezoelectric material having the above said orientation for allowing the propagation of the surface acoustic waves. If such material is of monocrystal type, it may be obtained by growth from a melting bath (system CZ) or, if it consists of a thin film on an inert substrate, it may be obtained by several known techniques, such as thermic evaporation, conventional sputtering or radiofrequency reactive sputtering or also in direct current, coating from vapour state or liquid epitaxis. On the exposed face of the active material there are carried out, by engraving or lithographic techniques, periodical (recurring) structures for emitting and receiving the surface acoustic waves. A typical structure of this kind is shown by the reference numeral 11 and comprises a first and a second comb-shaped structure 12, 13, having an exact interspace of the teeth, which have a length W corresponding to the width of the surface wave beam.

In Fig. 1 only one of such structures is shown. It should be understood that on the other end portion of the substrate ... 10 it is provided a corresponding structure for emitting and receiving the surface acoustic waves. The propagation rate and the attenuation constant of such waves depend, besides the mechanical finish of the surface, upon the physical characteristics of the substrate, so that the application of an electric field, which modifies the elastic constants of the piezoelectric plate, causes a variation of the propagation rate of the surface acoustic waves, variation which may be detected and measured.

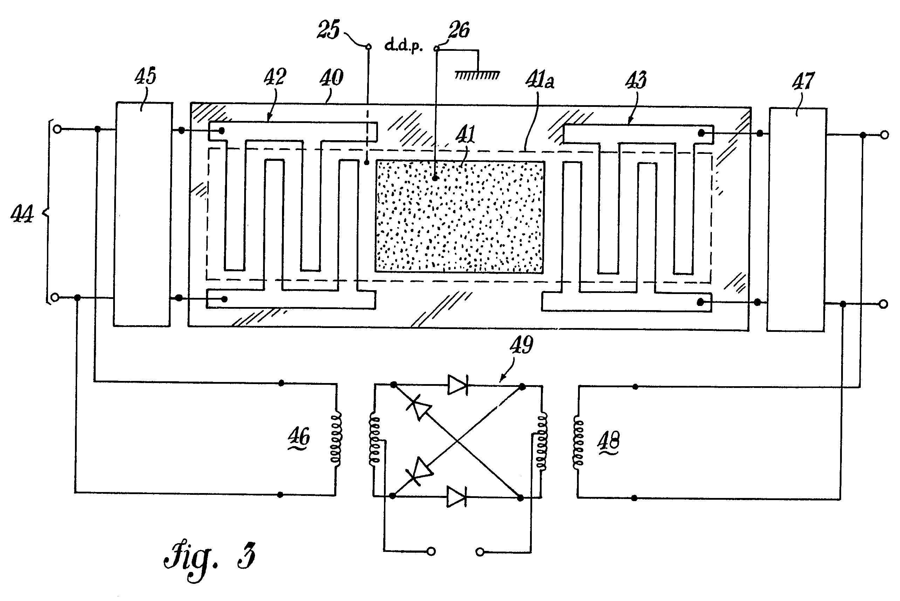

With reference to Fig. 2, it may be seen that the base element of the surface acoustic wave voltage sensor comprises a surface wave delay line, carried out on a piezoelectric substrate 20. On the opposite faces of said substrate there are applied by deposition, two metal films 23 and 24 for applying an electric field, whereas two interdigital transductors 21, 22 are formed on the piezoelectric substrate 20 by a thin metal film by conventional photographic techniques. A transductor emits the surface waves which are received after a time = L/V by the second transductor (L = distance between the centers of the two transductors, V = the propagation rate of the surface waves in the deposited piezoelectric metal film 23).

When a potential difference (p.d.) is applied to the two rheophores 25, 26, an electric field is generated within the substrate which owing to the piezoelectric effect causes a variation of the propagation rate of the surface waves. From the constructive point of view it is more advisable to connect the electorde 23 to the potential which is the nearest to that of the transductors 21 and 22, so as to avoid the discharges between said transductors and the electrode 23.

The variations of the propagation rate caused by the unknown p.d. may be detected and measured as phase difference with respect to the input of the signal received at the output of the delay line.

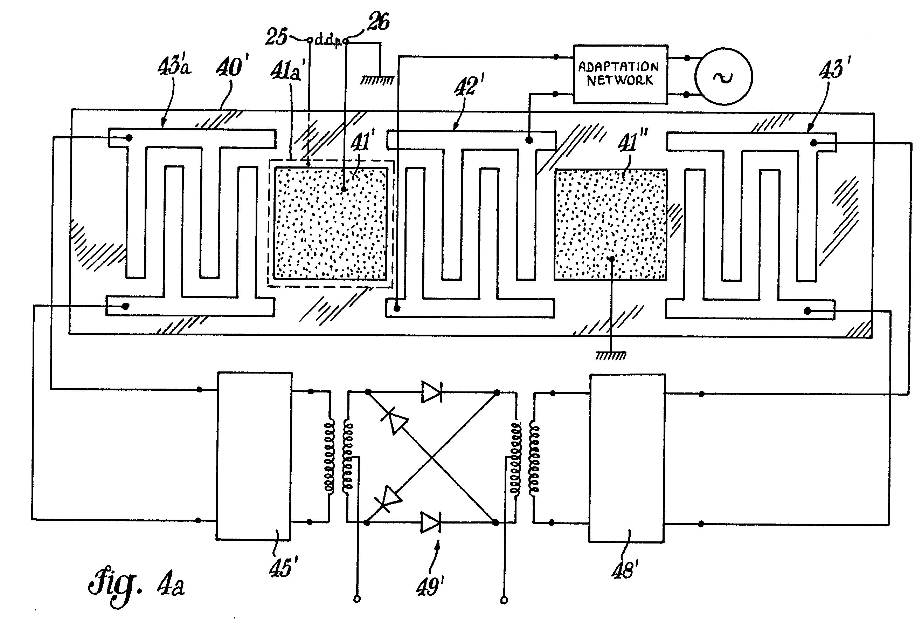

Fig. 3 shows a first embodiment and connection type of the surface acoustic wave voltage sensor. The sensitive element of the voltage sensor consists of a surface wave delay line carried out on the substrate 40, on the faces of which, likely as in the structure shown in Fig. 2, there are applied two field contact metal films 41, 41a, the unknown p.d. being applied to the rheophores 25, 26 thereof, an interdigital transmission structure 42 and an interdigital reception structure 43.

An input signal is applied to terminals 44 and through an adaptation network 45 it reaches the transmission structure 42. The input signal reaches also a first input 46 of a phase detector, well known in the art.

The signal emitted by the transmitting structure 42 passes through the zone of the sensitive film subjected to the electric field generated by the applied unknown p.d. and is received by the receiving structure 43 with a delay depending on the variation of the elastic characteristics of the applied electric field.

The output signal from the receiving structure 43 reaches, through an adaptor network 47, another input 49 of a phase detector 49.

It is clear, that in case of modification of the elastic characteristics of the piezoelectric substrate, there will occur variations of the propagation characteristics of the surface wave and consequently the output of a useful signal from the phase detector 49.

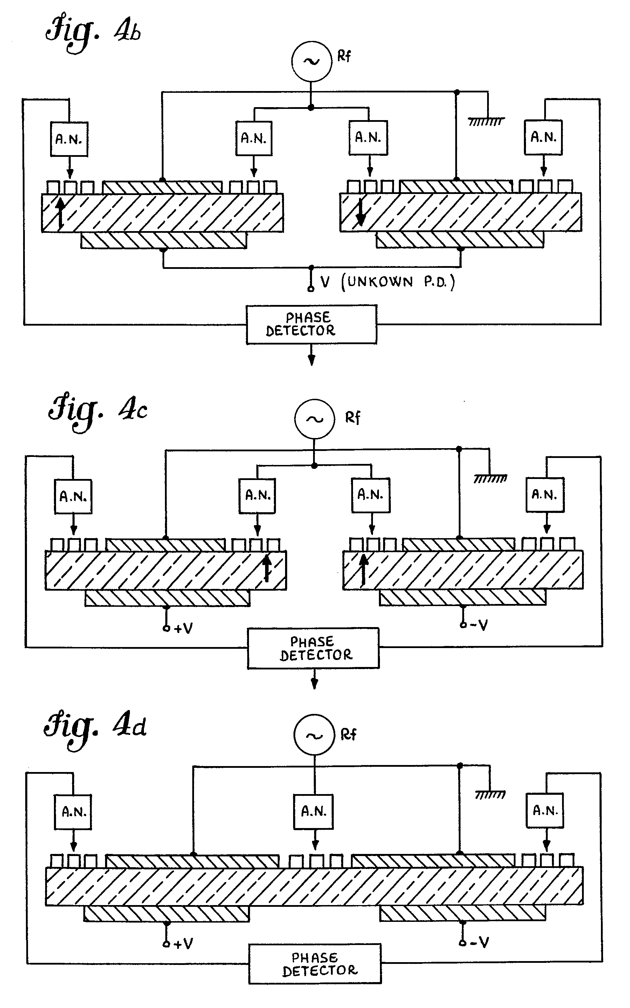

In Fig. 4a it is shown a structure substantially similar to that of Fig. 3, in which the principle of the differential modification between two different zones of the piezoelectric substrate is used. In this figure the parts corresponding to those of Fig. 3 are indicated with the same reference numerals but provided with apex.

Obviously, in the structure of Fig. 4a, only one zone of the dielectric substrate will be submitted to the action of the electric field due to the unknown p.d. to be detected, whereas the second zone serves as a reference zone. It should be noted that the electrode 41" is principally not indispensable, however, it allows to render perfectly simmetrical the two channels (in absence of an applied p.d.).

For one skilled in the art it will be clear that a structure of this kind has several advantages with respect to the structure of the absolute type as shown in Fig. 3, since the detection efficiency is not altered by aging and/or drift phenomena of the piloting signals. Moreover, by such a structure there are compensated the influences of the variations of temperature and outer pressure on the sensor.

The differential structure shown in Fig. 4b allows also to obtain a stabilization with respect to the variation of the ambient conditions (pressure, temperature) and, moreover, to double the sensitivity value of the sensor. This is attained by providing two delay lines on the two faces opposite with respect to the crystalographic orientation of the substrate. In this manner, an applied p.d. causes an increase of the propagation rate on one line and a decrease on the other one. Moreover, the symmetry of the sensor response to the changes of the voltage polarity is improved.

In the figure, the arrows shown on the piezoelectric substrates indicate the crystallographic orientations. The two films of the upper field are earth connected, the Rf gerator is connected to two adaptation networks whereas the other two adaptation networks are connected to the phase detector.

For measuring potential differences, balanced with respect to earth it may be used the structure shown in Fig. 4c, which may be carried out by two separate substrates or a single substrate, as shown in Fig. 4d. The structure of Fig. 4c, as demonstrated by the orientation arrows and obviously the structure of Fig. 4d differ from that of Fig. 4b by that the two delay lines are carried out on faces having the same sign with respect to the crystdallographic orientation of the substrate.

Referring now to Figs. 3, 4a, 4b, 4c and 4d it may be seen that the voltage sensor may measure also the alternate potential differences.

In this case the output voltage of the balanced modulator is alternate; its amplitude is proportional to the amplitude of the unknown p.d., whereas its frequency coincides with the frequency of the p.d. to be measured.

As to the limitations relating to the value of the frequency of the p.d. to be measured, this frequency should be sufficiently lower than the inverse of the time of passage of the surface wave between the two transductors forming the line. Bearing in mind the above said and considering the passage times in the range of one microsecond, the maximal frequency of the voltage to be measured is of about 500 $kH_z$.

Detection by oscillator

Bearing in mind that the structure as above disclosed has a variation of the passage time of the signal depending on the variation of the propagation rate caused by the p.d., it will be easy to apply the herebefore disclosed conceipts to the autooscillating devices.

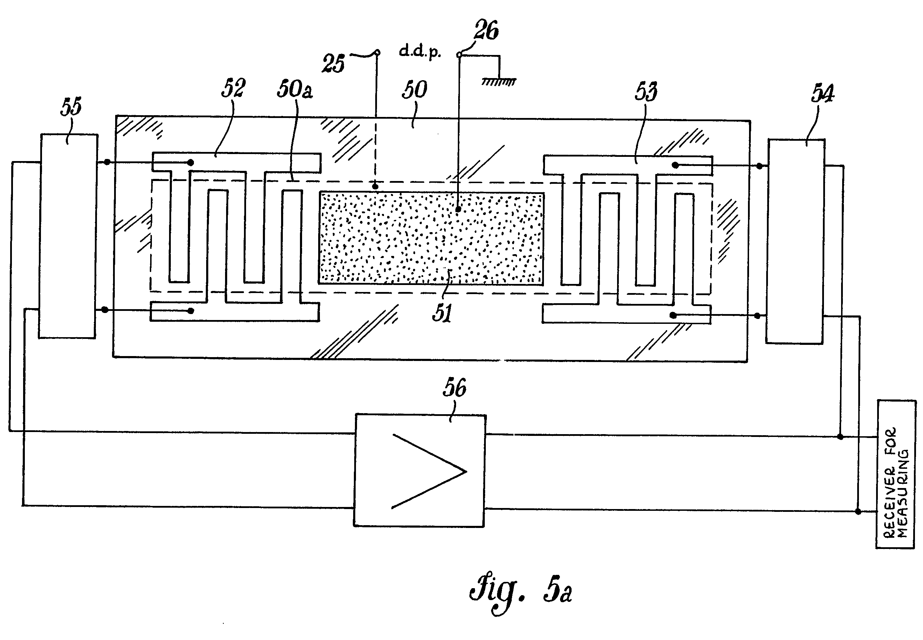

Structures of this kind are shown in Figs. 5a and 5b. Fig. 5a shows a structure having a substrate 50 with an upper electrode 51 connected to receiving and transmitting interdigital structures 52 respectively 53, coupled to adaptation networks 54, 55. On the opposite face a lower electrode 50a is shown in dashed line, which is connected to the p.d. to be measured. The terminals of the four poles outside of adaptation networks 54, 55 are connected to an amplifier 56 having a sufficient gain, so that the entire assembly may autooscillate. The oscillation frequency depends on the entire phase rotation which, in turn, depends upon the variations of the propagation rate caused by the applied p.d..

The structure shown in Fig. 5a is particularly adapted for measuring alternate p.d.. The detection may be performed by measuring the modulation index of the frequency of the output signal. In fact, on the output it results a frequency modulated signal having the instantaneous value of the applied p.d.. Since the frequency variations should be measured, the device is sufficiently insensitive to the phenomena of aging and/or drifting of the frequency.

On the contrary, in case of measuring a direct p.d., the absence of the reference frequency (frequency of applied null tension) renders not tolerable the uncertainty of measure. In this case a differential structure is shown in Fig. 5b. It comprises two identical oscillators, carried out on the faces opposite to the crystallographic orientation of the substrate. In absence of an applied p.d., the two oscillation frequencies are equal, whereas in presence of a p.d. one of the two frequencies increases, whereas the other one decreases.

The unknown p.d. may be measured by measuring the difference of the two frequencies (beat).

The differential structure allows to attain, likely as that shown in Figs. 4b, 4c and 4d, a stabilization towards the variation of the pressure and temperature and a better symmetry of the response to the changes of polarity of the applied voltage. For measuring a balanced p.d. with respect to earth it may be used the structure as shown in Fig. 5c, wherein two oscillators may be carried out on two separated substrates or on a single substrate, owing to that the delay lines are carried out on faces having the same sign with respect to the crystallographic orientation.

The detecting method by means of an oscillator is particularly interesting not only owing to its simplicity, but also owing to the possibility of directly performing the measure at a distance by irradiating the output signal. For this purpose the frequency of the oscillator may be suitably selected in accordance to the transmission requirements and taking into consideration the bands available for these services.

As already herebefore said, the signal in case of the sensor for the alternate voltage consists of a carrier of frequency equal to the frequency of the oscillator, frequency modulated by effect of the measured voltage. The frequency of the modulator coincides with the frequency of the measured voltage, whereas the modulation index is proportional to the amplitude of the voltage itself. The modulation frequency and the modulation index may be measured by a suitably adjusted receiver.

In case of a sensor for measuring direct voltages, the output signal is a beat of the output signals of the two oscillators and may be considered as a signal having a frequency carrier corresponding to the mean value of the two frequencies, modulated in its amplitude by a signal having a frequency corresponding to the difference of the two frequencies.

The measure of the voltage may be, in this case, obtained by detecting the output signal and measuring the frequency of the modulated signal.

A structure having a thin piezoelectril film

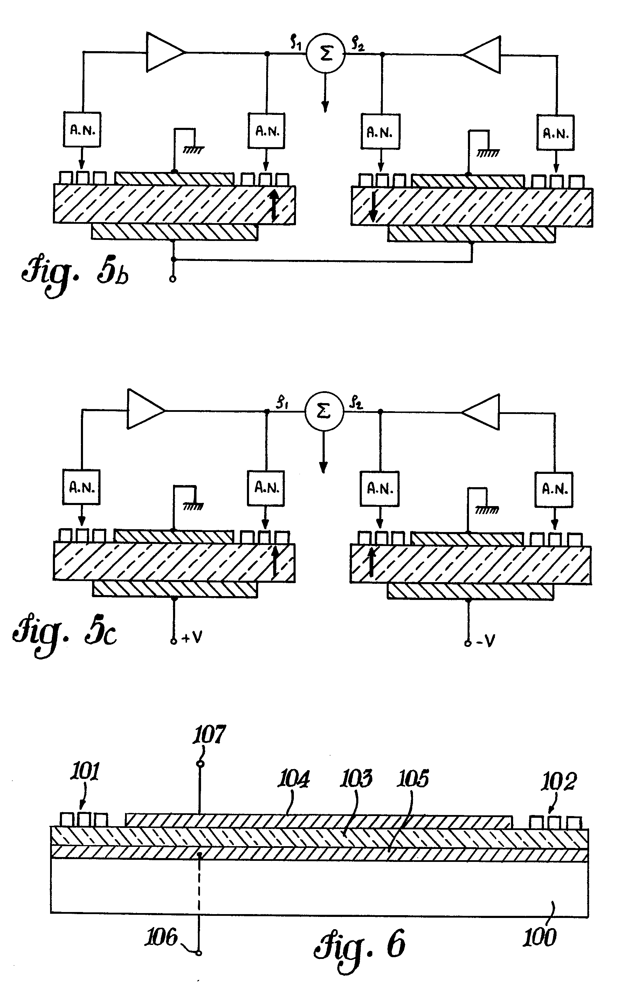

The technology of the surface acoustic waves provides an always increasing use of structures carried out on non-piezoelectric substrates and employing thin piezoelectric films of suitable materials (the most common are ZnO, AlN, ZnS). The proposed device may employ this type of technology and assumes the base configuration shown in Fig. 6.

In this case, since the thickness of the piezoelectric film is very thin (the thickness of the film ranges usually from 1/20 to 1/2 of the acoustic length of the acoustic wave in the medium), At the same p.d. the electric field is much more intense and the structure is suitable to be used for measuring lowest potential differences.

In the figure the non-piezoelectric substrate is indicated with the reference numeral 100, the transmitting and receiving transductors are indicated respectively by the reference numerals 101 and 102; the piezoelectric film is indicated by 103, the two electrodes or field films by 104 and 105 and the two rheophores by 106 and 107.

The present invention has been disclosed with reference to its embodiments as presently preferred, but it is understood that several changes and modifications may be made by one skilled in the art without departing from the scope thereof.

CLAIMS:

1. A surface acoustic wave voltage sensor characterized in that it comprises a surface acoustic wave structure, the propagation sector of the surface acoustic wave of which is submitted to the action of an unknown potential difference (p.d.), the arrangement being such that the application of the unknown p.d. causes the modification of the propagation characteristics of the surface acoustic wave.

2. A surface acoustic wave voltage sensor, characterized in that it comprises a substrate of piezoelectric material adapted to substain the propagation of the surface acoustic waves; an interdigital structure for emitting the surface acoustic waves and an interdigital structure for receiving the surface acoustic waves; a first and second metal field film applied onto the opposite faces of said substrate, provided for applying the unknown potential difference, the structure being such that the application of the unknown potential difference causes the modification of elastic characteristics of the substrate by the piezoelectric effects and a consequent detectable variation of the propagation characteristics of the surface acoustic waves; as well as a circuitry for detecting and measuring the variation of said propagation characteristics, particularly of the propagation rate of the surface acoustic waves.

3. A surface acoustic wave voltage sensor as claimed in claim 2, characterized in that said first and second metal films for applying the unknown potential difference are applied by deposition onto said piezoelectric substrate.

4. A surface acoustic wave voltage sensor as claimed in claim 2, characterized in that said emitting and receiving interdigital structures are carried out by photolithographic structures.

5. A surface acoustic wave voltage sensor as claimed in claim 2, characterized in that said piezoelectric substrate consists of a thin film of a piezoelectric material applied onto a support substrate, for example of glass, by previous interposition of a metal film for application of a field.

6. A surface acoustic wave voltage sensor as claimed in any of the preceding claims, characterized in that said structure for emitting the surface acoustic waves is coupled to a radio-frequency generator with a frequency proportional to physical constants of the surface acoustic wave structure and to the reference gate of a phase detector, the signal door of which is coupled to the receiving gate of the surface acoustic waves, the arrangement being such that said phase detector emits an output signal only owing to a variation of the propagation characteristics of the surface acoustic waves caused by the application of a potential difference to said field films.

7. A surface acoustic wave voltage sensor according to anyone of claims 1 to 5, characterized in that the outer circuitry of said sensor comprises a pair of identical surface acoustic structures, only one of which is subjected to the potential difference to be detected in an electrically balanced arrangement, the measure being carried out by detecting the unbalance inducted by the modification of the elastic constants of the piezoelectric substrate under the effect of the induced field of the unknown difference potential.

8. A surface acoustic wave voltage sensor according to anyone of claims 1 to 5, characterized in that the outer circuitry of said sensor consists of an oscillator, in which said surface acoustic wave device forms an element for determination of the oscillation frequency, the measure being carried out by measuring the difference between the frequency of the reference oscillation and that of the oscillation as modified owing to the modification of the elastic constant of the piezoelectric substrate under the action of the inducted field of the unknown potential difference.

9. A surface acoustic wave voltage sensor according to anyone of claims 1 to 5, characterized in that it comprises two surface acoustic wave structures carried out on two separate piezoelectric substrates having opposite crystallographic orientations, the potential difference being applied to field electrodes connected to one another.

10. A surface acoustic wave voltage sensor according to anyone of claims 1 to 5, characterized in that it comprises two surface acoustic wave structures carried out on two separate piezoelectric substrates having similar crystallographic orientations, the two homogeneous field electrodes being earth connected and the unknown potential difference being applied with opposite signs to other two homogeneous field electrodes.

11. A surface acoustic wave voltage sensor according to claim 10, characterized in that said two surface acoustic wave structures are carried out on a single piezoelectric substrate.

0166065

**Fig. 1**

**Fig. 2**

Fig. 3

0166065

*fig. 4a*

0166065

*Fig. 4b*

*Fig. 4c*

*Fig. 4d*

-5-

Fig. 5a

RECEIVER FOR MEASURING

26
25
d.d.p.
50
50a
51
52
53
54
55
56

$\textit{Fig. 5}b$

$\textit{Fig. 5}c$

$\textit{Fig. 6}$

European Patent
Office

**EUROPEAN SEARCH REPORT**

Application number

EP 84 83 0198

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 061 033 (MATSUSHITA ELECTRIC INDUSTRIAL CO., LTD.) * Page 7, line 12 - page 10, line 19; figure 1 * | 1-3,6 | G 01 R 29/24 G 10 K 11/36 H 03 H 9/42 |
| X | JAPANESE JOURNAL OF APPLIED PHYSICS, vol. 20, suppl. 20-3, 1981, pages 197-200, Tokyo, JP; Y. KASAHARA et al.: "An electrostatic voltage sensor using surface acoustic waves" * Pages 197-200 * | 1,2,6-8 | |
| X | REVIEW OF SCIENTIFIC INSTRUMENTS, vol. 54, no. 8, August 1983, pages 1012-1016, American Institute of Physics, New York, US; S.G. JOSHI: "Surface acoustic-wave device for measuring high voltages" * Page 1012 - page 1013, left-hand column; page 1015, left-hand column, last paragraph - right-hand column, paragraph 1; figures 1,2,5 * | 1,2,6-8 | |

TECHNICAL FIELDS
SEARCHED (Int. Cl.4)

G 01 R
G 10 K
H 03 H

The present search report has been drawn up for all claims

| Place of search | Date of completion of the search | Examiner |
|---|---|---|
| THE HAGUE | 04-03-1985 | KUSCHBERT D.E. |